# EUROPEAN PATENT APPLICATION

(11) **EP 1 670 096 A2**
(43) Date of publication of application: **14.06.2006**
(21) Application number: 05024120.7
(22) Date of filing: 04.11.2005
(51) Int. Cl.: H01Q 23/00, H01Q 1/24, H03F 3/193, H03H 7/38

(54) **Antenna module for receiving signal having a broadcasting frequency**

(30) Priority: 05.11.2004 KR 2004089704
(71) Applicant: Ace Technology, Namdong-gu Incheon 405-822 (KR)
(72) Inventor: Hong, Ju-Seok, Seoul 158-824 (KR); Lee, Cheon-Hee, Seongnam-si Gyeonggi-do, 463-804 (KR)
(74) Representative: Dilg, Andreas

(57) **Abstract**

The present invention relates to an antenna module for receiving a signal having broadcasting frequency in a mobile terminal. The antenna module includes: an antenna element having a length shorter than a 1/2 wavelength of a receiving frequency; and an active impedance matching unit connected to one end of the antenna element for matching impedance of the antenna element to a predetermined load impedance.

## Description

### Field of the Invention

The present invention relates to an antenna module for receiving a signal having a broadcasting frequency in a mobile terminal; and, more particularly, to an apparatus for matching impedance of an antenna module for receiving a signal having the broadcasting frequency using an active element.

### Description of Related Arts

Broadcasting services, i.e., digital audio broadcasting (DAB) and digital multimedia broadcasting (DMB), are recently provided to the general public, and a user generally use a mobile terminal such as a portable phone, a notebook personal computer (PC) and a personal digital assistance (PDA) to receive a broadcasting signal through VHF or UHF bands. It is also expected that communication and broadcasting service including AM or FM broadcasting, digital TV and HDTV will be provided to the general public in near future.

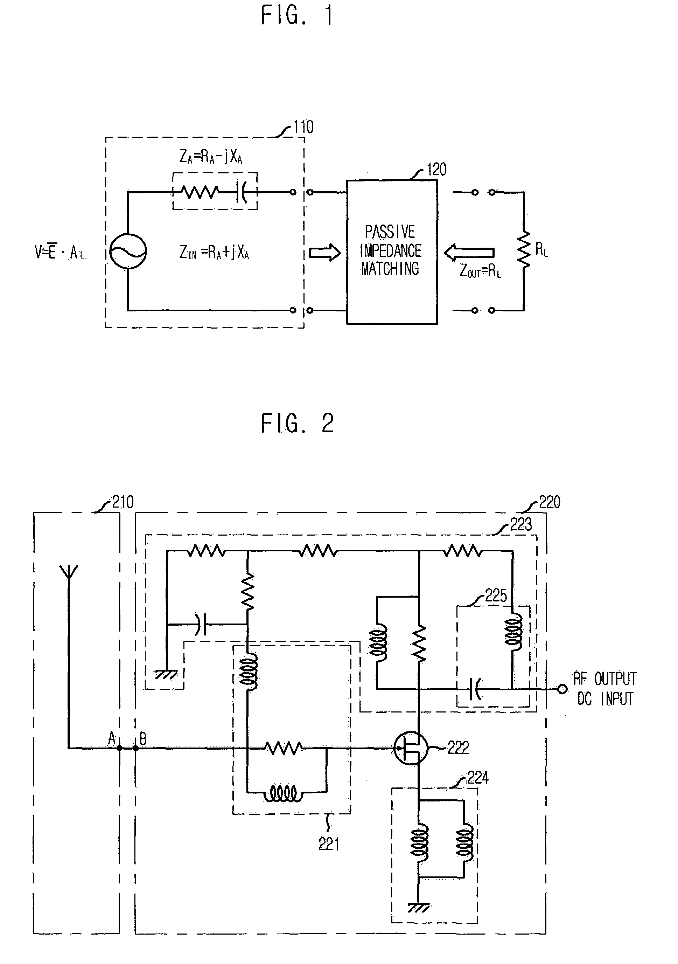

Fig. 1 is a diagram illustrating an antenna module for receiving a signal having broadcasting frequency in accordance with the related art. As shown in Fig. 1, the antenna module uses a passive element 120 to match impedance. That is, the conventional antenna module using the passive element has a structure that is simply operated by resonance. Therefore, the conventional antenna module must be designed to have a proper length so that the antenna module is resonated by the frequency of the received signal. For example, a dipole antenna must have a length corresponding to 1/2 wavelength of the frequency of the received signal and a monopole antenna must have a length corresponding to 1/4 wavelength of the frequency of the received signal. A conventional antenna module having a length corresponding to 1/2 wavelength of the frequency of the received signal simply transforms the impedance of free space to be identical to impedance of a typical receiver, for example, to 75 ohm. Antenna modules having such characteristics are widely used to receive currently available broadcasting services.

If the conventional antenna module is used to receive signals of bands such as VHF, UHF, AM and FM broadcasting, the antenna module must be lengthened since the length of the antennal module is in inverse proportional to the frequency. For example, a dipole antenna of 1/2 wavelength must be lengthened to 75cm in order to receive signals of 200MHz broadcasting band. In case of the monopole antenna of 1/4 wavelength, the length of the monopole antenna must be lengthened to 37.5cm to receive signals of 200MHz. Therefore, there is a limitation to implement the conventional antenna module using the passive element in the mobile terminal because the mobile terminals have been miniaturized and integrated.

When broadcasting signals are received using an antenna having an antenna module shorter than 1/8 wavelength of the received signal, it is very difficult to match impedance between a receiver and the antenna module only using a passive impedance matching unit. Although the impedance matching between the receiver and the antenna module is achieved, it is very difficult to have a proper band characteristic for reception of the broadcasting signal since the impedance is matched in very narrow band. Therefore, designing of the impedance matching unit 120 becomes very complicated in order to have wide-band characteristics in the antenna module. Although the impedance matching unit 120 is designed to have the wide-band characteristics, greater loss is arisen in the impedance matching unit 120. Therefore, antenna characteristics would be degraded due to the great loss arisen in the impedance matching unit 120.

### Summary of the Invention

It is, therefore, an object of the present invention to provide an antenna module for receiving a signal having broadcasting frequency, which includes a small antenna element having wide-band characteristics by using an active impedance matching unit.

In accordance with an aspect of the present invention, there is provided an antenna module for reception of broadcasting frequency signal using in a mobile terminal, the antenna module including: an antenna element having a length shorter than a wavelength tat corresponding to 1/2 wavelength of the received signal; and an active impedance matching unit connected to one end of the antenna element for matching impedance of the antenna element to a predetermined load impedance.

The active impedance matching unit may include: a high input impedance unit for maintaining high input impedance in the frequency band of the received signal; and an amplifying circuit connected to the high input impedance unit to match to a predetermined load impedance.

The amplifying circuit may include a gate connected to the high input impedance unit, a drain connected to a bias and output unit, and a source connected to the ground through a stabilizing unit.

The bias and output unit may be supplied DC voltage, and output the signal which can be transformed to 50 or 75 ohm signal easily at the frequency of the received signal.

The antenna element may be one of a dipole antenna, a monopole antenna, a patch antenna, a helical antenna and a reverse-F antenna.

The antenna element may be disposed at an inside of a mobile terminal or at an outside of the mobile terminal.

It is preferable that the length of the antenna element may be about same to or shorter than 1/8 wavelength of the frequency.

The amplifying element may be a field effect transistor (FET), a high electron mobility transistor (HEMT) or a bipolar junction transistor (BJT).

### Brief Description of the Drawings

The above and other objects and features of the present invention will become better understood with regard to the following description of the preferred embodiments given in conjunction with the accompanying drawings, in which:
Fig. 1 is a diagram illustrating an antenna module for reception of broadcasting frequency signal in accordance with the related art;
Fig. 2 is a diagram of an antenna module for reception of broadcasting frequency signal in accordance with a preferred embodiment of the present invention;
Fig. 3 is an equivalent circuit diagram of an antenna module for reception of broadcasting frequency signal in accordance with a preferred embodiment of the present invention;
Fig. 4 is a graph of a simulation result representing that a gain between an input end and an output end in an impedance matching unit is 14.215dB when the frequency is 200MHz in accordance with a preferred embodiment of the present invention; and
Fig. 5 shows a simulation result representing that a return loss of an output end of an impedance matching unit is -21.918dB when the frequency is 200MHz in accordance with a preferred embodiment of the present invention.

### Detailed Description of the Invention

Hereinafter, an antenna module for reception of broadcasting frequency signal will be described in more detail with reference to the accompanying drawings.

Fig. 2 is a circuit diagram of an antenna module for reception of broadcasting frequency signal in accordance with a preferred embodiment of the present invention.

Referring to Fig. 2, the antenna module according to the present invention includes an antenna element 210 and an active impedance matching unit 220.

The antenna element 210 is shorter than a length corresponding to 1/2 wavelength of a radiated signal. For example, the antenna element 210 is about same to or shorter than a length corresponding to 1/8 wavelength of the frequency of the received signal. If an antenna element of 1/10 wavelength in 200MHz, the length of the antenna element may be 15cm.

The active impedance matching unit 220 is connected to one end of the antenna element 210 and includes a high-input impedance unit 221, an amplifying element 222, a bias and output unit 223, and a stabilizing unit 224.

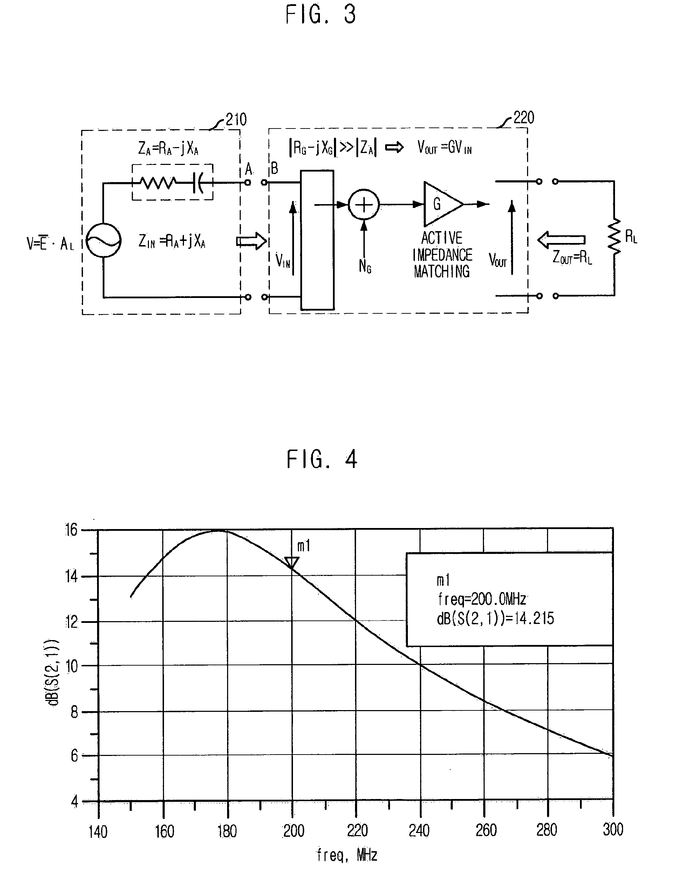

As shown in Fig. 3, the high-input impedance unit 221 enables the active impedance matching unit 220 to have greater impedance at a location B than impedance of the antenna element 210 at a location A. For example, the impedance of the active impedance matching unit 220 at the location B may be more than 10 times greater than the impedance of the antenna element 210 at the location A. Due to the greater impedance at the location B, the received signal voltage of the frequency of the received signal is mostly applied between the position B and the ground. Accordingly, high power gain can be obtained at the following end. Furthermore, the antenna module can have characteristics that fix impedance at a following end of the amplifying element as a predetermined level in whole wide-band.

Since the amplifying element 222 has characteristics of having impedance of constant level without reference to the level of impedance applied at the high-input impedance unit 221 comparing to a passive element, it is easy to transform the impedance to be in a range of 50 to 75 ohm which is generally used at an output end of the amplifying element 222.

That is, the amplifying element 222 greatly divides voltage element of a signal to have greater impedance than impedance applied at the high-input impedance 221. (voltage divider rule)

It is preferable to use a field effect transistor (FET) as the amplifying element.

The bias and output unit 223 receives a DC voltage, applies the bias voltage to the amplifying element 222, matches target impedances, and outputs the frequency of the received signal signal. Especially, the bias and output unit 223 properly determines device value of an output matching unit 225 to match the target impedances.

Hereinafter, equations shown in Fig. 3 will be described.

Referring to Fig. 3, the equation *V* = E̅ • *A*_{*L*} means that the voltage of the received signal is expressed as product of intensity of electric field and a size of the antenna element.

The equation *Z*_{*A*} *= R*_{*A*} *- jX*_{*A*} denotes the impedance of the antenna element.

The equation Z_{*IN*} *= R*_{*G*} + *jX*_{*G*} represents the impedance at an input end of the impedance matching unit.

*V*_{*IN*} denotes voltage element of a signal applied at an impedance input end by the impedance of the input end of the impedance matching unit. *N*_{*G*} denotes noise and power element added on the impedance matching unit. *G* denotes a gain obtained at the impedance matching unit.

The equation |*R*_{*G*}*+ jX*_{*G*}| ≻≻ | Z_{A} | shows that the impedance matching unit has greater impedance than the antenna element.

The equation *V*_{*OUT*} *= GV*_{*IN*} denotes that the voltage element of the input signal is amplified as much as a gain and is outputted to an output end of the impedance matching unit.

The equation *Z*_{*OUT*} *= R*_{*L*} denotes that the impedance of the output end of the impedance matching unit is load of the output end of the impedance matching unit.

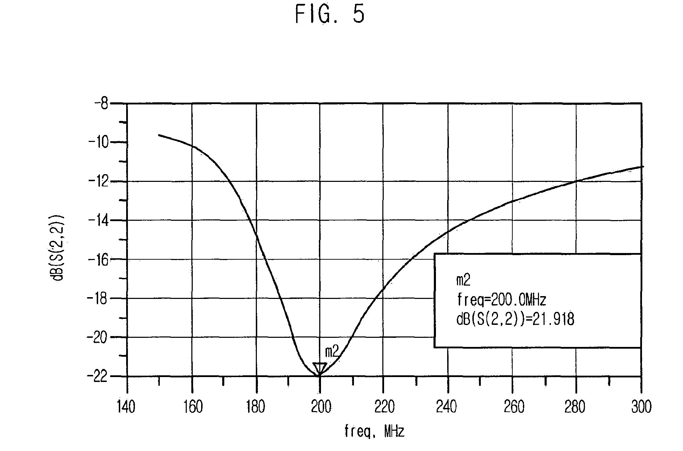

Figs. 4 and 5 are graphs showing simulation results in accordance with a preferred embodiment of the present invention.

Fig. 4 is a graph of a simulation result representing that a gain between the input end and the output end of the impedance matching unit is 14.215dB when the frequency is 200MHz, and Fig. 5 shows a simulation result representing that a return loss of an output end of the impedance matching unit is -21.918dB when the frequency is 200MHz.

The antenna module for reception of broadcasting frequency signal according to the present invention is suitable to the integrated and miniaturized mobile terminal. Also, The antenna module according to the present invention has superior wide-band characteristics for reception of broadcasting frequency signal.

As described above, the antenna module according to the present invention includes the amplifying element. Accordingly, the noise power may become greater because the noise level increases by the amplifying element. However, it can be ignored because a thermal noise on air is much greater than the noise level increased by the amplifying element in frequency bands about under 200Mz.

The present application contains subject matter related to Korean patent application No. KR 2003-0093207, filed in the Korean patent office on December 18, 2003, the entire contents of which being incorporated herein by reference.

While the present invention has been described with respect to certain preferred embodiments, it will be apparent to those skilled in the art that various changes and modifications may be made without departing from the spirits and scope of the invention as defined in the following claims.

## Claims

1. An antenna module for receiving a signal having broadcasting frequency in a mobile terminal, the antenna module comprising:
an antenna element having a length shorter than a 1/2 wavelength of the received signal; and
an active impedance matching unit connected to one end of the antenna element for matching impedance of the antenna element to a predetermined load impedance.

2. The antenna module as recited in claim 1, wherein the active impedance matching unit includes:
a high input impedance unit for maintaining high input impedance in the frequency band of the received signal; and
an amplifying circuit connected to the high input impedance unit to match to a predetermined load impedance.

3. The antenna module as recited in claim 2, wherein the amplifying circuit includes a gate connected to the high input impedance unit, a drain connected to a bias and output unit, and a source connected to the ground through a stabilizer, where the bias and output unit is supplied a DC voltage, applies a bias voltage and outputs the received signal.

4. The antenna as recited in claim 3, wherein the length of the antenna element is about same to or shorter than 1/8 wavelength of the frequency of the received signal.

5. The antenna as recited in claim 1, wherein the antenna element is one of a dipole antenna, a monopole antenna, a patch antenna, a helical antenna and a reverse-F antenna.

6. The antenna as recited in claim 5, wherein the antenna element is disposed at an inside of a mobile terminal.

7. The antenna as recited in claim 6, wherein the amplifying element is a field effect transistor (FET) or a high electron mobility transistor (HEMT).

8. The antenna as recited in claim 5, wherein the antenna element is externally disposed at the mobile terminal.

9. The antenna as recited in claim 8, wherein the amplifying element is a field effect transistor (FET) or a high electron mobility transistor (HEMT).
